(19) Europäisches Patentamt / European Patent Office / Office européen des brevets

(11) **EP 2 031 656 A2**

(12) **DEMANDE DE BREVET EUROPEEN**

(43) Date de publication:
**04.03.2009 Bulletin 2009/10**

(51) Int Cl.:
***H01L 23/544*** *(2006.01)*

(21) Numéro de dépôt: **08156761.2**

(22) Date de dépôt: **22.05.2008**

| | |
|---|---|
| (84) Etats contractants désignés:<br>**AT BE BG CH CY CZ DE DK EE ES FI FR GB GR HR HU IE IS IT LI LT LU LV MC MT NL NO PL PT RO SE SI SK TR**<br>Etats d'extension désignés:<br>**AL BA MK RS** | (71) Demandeur: **Commissariat A L'Energie Atomique - CEA**<br>**75015 Paris (FR)** |
| (30) Priorité: **01.06.2007 FR 0755405** | (72) Inventeur: **Vinet, Maud**<br>**38140, Rives (FR)** |
| | (74) Mandataire: **Ilgart, Jean-Christophe**<br>**BREVALEX**<br>**3, rue du Docteur Lancereaux**<br>**75008 Paris (FR)** |

(54) **Dispositif de mesure de résistivité de contact métal/semi-conducteur**

(57) Dispositif (100) de mesure de résistivité $\rho_c$ d'une interface entre un semi-conducteur (104) et un métal (119), comportant au moins :
- une couche diélectrique (102),
- au moins un élément (104), à base du semi-conducteur, disposé sur la couche diélectrique, de forme sensiblement rectangulaire, ayant une face de longueur L et de largeur W en contact avec la couche diélectrique et ayant une épaisseur t,
- au moins deux portions d'interface (119) à base du métal ou d'un alliage dudit semi-conducteur et dudit métal, chacune de deux faces opposées de l'élément semi-conducteur, de surface égale à t × W et perpendiculaires à la face en contact avec la couche diélectrique, étant complètement recouverte par une des portions d'interface.

FIG.8

**Description**

**DOMAINE TECHNIQLTE ET ART ANTÉRIEUR**

L'invention concerne un dispositif permettant d'effectuer une mesure précise de résistivité de contact d'une interface entre un semi-conducteur et un métal, ou entre le semi-conducteur et un alliage du métal et du semi-conducteur. L'invention est particulièrement adaptée aux interfaces verticales dont les dimensions correspondent à celles que l'on trouve dans des transistors sur film mince actuels, par exemple formées par la surface latérale d'un élément d'épaisseur comprise entre environ 1 nm et 50 nm et de largeur comprise entre environ 30 nm et quelques microns (typiquement 2 $\mu$m).

L'invention peut être utilisée pour caractériser précisément des paramètres électriques de matériaux, ou pour optimiser, par le choix des matériaux, des transistors CMOS à source et drain métalliques.

Il existe actuellement plusieurs types de dispositif pour effectuer des mesures de résistivité de contact entre un métal et un semi-conducteur.

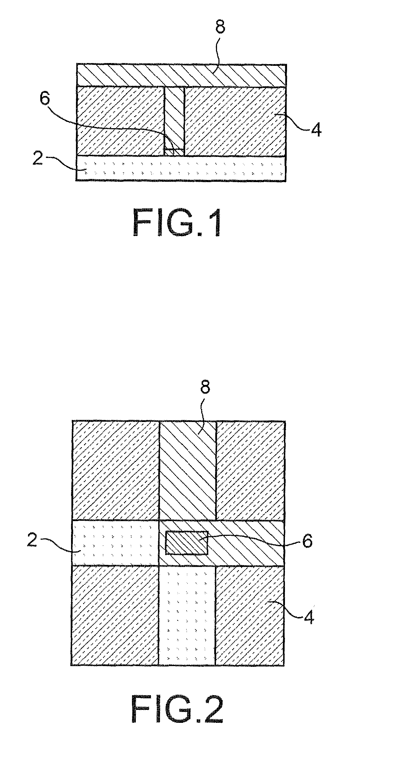

Des dispositifs de type « Cross Kelvin Resistor » (CKR) permettent de mesurer la résistance Kelvin d'une interface formée par un métal et un semi-conducteur, dont une approximation est égale à $R_K = \rho_c \times S_K$, où $S_K$ est la surface d'un trou de contact réalisé sur une couche à base du semi-conducteur dans lequel est déposée une portion du métal, formant ainsi l'interface dont on cherche à mesurer la résistivité de contact $\rho_c$. Les figures 1 et 2 représentent respectivement une vue en coupe et une vue de dessus d'un tel dispositif. Le dispositif CKR comporte un substrat 2 à base d'un semi-conducteur, par exemple du silicium, un diélectrique de contact 4, par exemple du $SiO_2$, une portion d'un premier métal ou siliciure 6 en contact avec le substrat 2, et un second métal 8 contactant électriquement le premier métal 6. Le semi-conducteur 2 et le premier métal 6 forment l'interface dont la résistance $R_K$ est destinée à être mesurée par l'intermédiaire de mesures de courants et de tensions entre le second métal 8 et le semi-conducteur 2.

Toutefois, ce dispositif CKR est uniquement adapté pour mesurer une résistivité de contact d'une interface horizontale entre le premier métal 6 et le semi-conducteur 2, c'est-à-dire parallèle au plan formé par le substrat semi-conducteur 2. Or, la résistivité mesurée à partir d'une telle interface horizontale n'est pas représentative de la résistivité de contact d'une interface entre le métal et le semi-conducteur en couche mince réalisée par exemple dans un transistor MOS du fait de l'espace disponible dont dispose le métal pour créer l'interface, c'est-à-dire de la surface de l'interface, et du fait des contraintes pouvant faciliter la formation de différents alliages au niveau de l'interface. De plus, comme cela est décrit dans les documents « Electrical modelling of kelvin structures for the derivation of low specific contact resistivity » de G. Reeves et al, ESSDERC 1997, et « New challenges of the modelling of electrical characterization of ohmic contacts for ULSI devices » de A.S. Holland et al, international Conf of Microelec (MIEL), 2000, de nombreuses modélisations et simulations numériques sont nécessaires pour extraire la valeur exacte de $\rho_c$ car des lignes de champ se dispersent dans le substrat semi-conducteur 2. Ainsi avec ce dispositif, il est difficile d'extraire une valeur exacte de la résistivité spécifique de contact de l'interface. Enfin, ce dispositif nécessite la réalisation technologique d'un via ou trou de contact imposant des dimensions minimales pour une technologie donnée. Ainsi, pour le noeud technologique 22 nm, les dimensions des contacts sont d'environ 40 nm, ce qui est incompatible avec un canal de transistor dont l'épaisseur est égale à environ 10 nm.

Des dispositifs de type « Contact End Resistor » (CER) ou « Transmission Line Tap Resistor » (TLTR) permettent également de mesurer la résistance de contact d'une interface métal/semi-conducteur. Mais dans ces deux cas, comme cela est décrit dans le document « 2D simulations for accurate extraction of the specific contact resistivity from contact résistance data » de W.M. Loh et al, IEDM 1985, page 25.1, il est très difficile d'accéder de manière précise à la résistance de contact, et donc à la résistivité de contact, à cause de l'incertitude concernant la forme des lignes de courant dans de telles structures. De plus, ces dispositifs CER et TLTR sont uniquement adaptés pour mesurer des résistivités d'interfaces horizontales.

Le document "Measurement of low Schottky barrier heights applied to metallic source/drain metaloxide-semiconductor field effect transistors" de E.Dubois et al, Journ. Of Appl. Phys., page 729, 2004, décrit une structure à diodes tête-bêche permettant de réaliser des mesures de hauteur de barrière Schottky, mais ne donnant pas accès directement à la résistivité de contact. Ce type de structure ne comporte qu'un seul contact à chaque extrémité de la structure, ce qui empêche la mesure de résistivité. De plus, au niveau de l'extraction, pour obtenir les mesures de hauteur de barrière Schottky, il est nécessaire de réaliser des mesures en température.

**EXPOSÉ DE L'INVENTION**

Un but de la présente invention est de proposer une nouvelle structure de mesure qui permette d'accéder à la résistivité de contact d'une interface entre un métal ou un alliage semi-conducteur/métal, qui avantageusement pourra être un siliciure dudit métal, et un semi-conducteur.

Pour cela, la présente invention propose un dispositif de mesure de résistivité $\rho_c$ d'une interface entre un semi-conducteur et un métal, comportant au moins :

- une couche diélectrique,
- au moins un élément, à base du semi-conducteur, disposé sur la couche diélectrique, de forme sensiblement rectangulaire, ayant une face de longueur L et de largeur W en contact avec la couche diélectrique et ayant une épaisseur t,
- au moins deux portions d'interface à base du métal ou d'un alliage dudit semi-conducteur et dudit métal,

chacune de deux faces opposées de l'élément semi-conducteur, de surface égale à t $\times$ W et perpendiculaires à la face en contact avec la couche diélectrique, étant complètement recouverte par une des portions d'interface.

L'élément disposé sur la couche diélectrique peut être constitué du semi-conducteur et/ou être un élément de semi-conducteur. Les portions d'interface peuvent être constituées du métal ou d'un alliage du semi-conducteur et du métal et/ou être des portions d'interface de métal ou d'un alliage du semi-conducteur et du métal.

Ce dispositif unitaire permet de mesurer la résistivité de contact entre un semi-conducteur et un métal en fonction de l'orientation cristalline du semi-conducteur, par exemple en choisissant l'orientation de départ du semi-conducteur ou bien en dessinant des structures qui sont orientées selon différentes directions sur le masque utilisé pour la lithographie.

Ce dispositif est adapté aux géométries de transistors avec des zones de source et drain métalliques.

De plus, contrairement aux dispositifs de l'art antérieur où les interfaces sont toutes horizontales, ce dispositif a une géométrie correspondant à la réalité des dispositifs comportant des interfaces formées par le métal et le semi-conducteur testés, par exemple des transistors. La taille des grains des matériaux peut alors être considérée comme représentative car la fabrication des matériaux prend en compte les contraintes propres à la géométrie verticale des interfaces, par exemple en prenant en compte les contraintes, lors de la réalisation de siliciures, qui modifient les diagrammes de phase binaire, ternaire, quarternaire des matériaux.

Enfin, ce type de dispositif unitaire conduit à une mesure de résistivité réelle car les lignes de champ sont parallèles au niveau de la mesure grâce à l'utilisation d'un substrat par exemple de type SOI (silicium sur isolant), l'élément semi-conducteur étant alors à base de silicium et disposés sur une couche diélectrique.

Le dispositif peut comporter en outre :

- au moins deux autres éléments à base du semi-conducteur, disposés sur la couche diélectrique, chacun de ces deux éléments étant de forme sensiblement rectangulaire, ayant une face de longueur L et de largeur W en contact avec la couche diélectrique, et ayant une épaisseur t sensiblement similaire à l'épaisseur des autres éléments, les largeurs W des trois éléments semi-conducteurs étant différentes les unes des autres, au moins deux des trois longueurs L des trois éléments semi-conducteurs étant différentes l'une de l'autre,
- au moins quatre autres portions d'interface à base du métal ou d'un alliage dudit semi-conducteur et dudit métal,

chacune de deux faces opposées d'un des deux autres éléments semi-conducteurs, de surface égale à t $\times$ W et perpendiculaires à la face en contact avec la couche diélectrique, étant complètement recouverte par une des quatre autres portions d'interface.

On forme ainsi un assemblage de plusieurs dispositifs unitaires permettant la mise en oeuvre d'une méthode de mesure pour l'extraction de la résistivité $\rho_c$ d'une interface entre un semi-conducteur et un métal.

La présente invention peut également concerner un dispositif de mesure de résistivité $\rho_c$ d'une interface entre un semi-conducteur et un métal, pouvant comporter au moins :

- une couche diélectrique,
- au moins trois éléments à base du semi-conducteur disposés sur la couche diélectrique, chaque élément étant de forme sensiblement rectangulaire, ayant une face de longueur L et de largeur W en contact avec la couche diélectrique, et ayant une épaisseur t sensiblement similaire à l'épaisseur des autres éléments, les largeurs W des trois éléments étant différentes les unes des autres, au moins deux des trois longueurs L des trois éléments étant différentes l'une de l'autre,
- au moins six portions d'interface à base du métal ou d'un alliage dudit semi-conducteur et dudit métal,

chacune de deux faces opposées d'un élément semi-conducteur, de surface égale à t $\times$ W et perpendiculaires à la face en contact avec la couche diélectrique, pouvant être complètement recouverte par une des portions d'interface.

Chaque portion d'interface peut être reliée électriquement à au moins deux contacts métalliques.

Chaque contact métallique peut comporter un empilement de couches métalliques, ces couches métalliques pouvant être à base de nitrure de titane et de tungstène.

Les portions d'interface peuvent être à base de siliciure dudit métal.

Les largeurs W et les longueurs L peuvent être comprises entre environ 30 nm et 2 $\mu$m.

Le semi-conducteur peut être du silicium, et/ou du germanium et/ou du silicium-germanium, le métal pouvant être du platine, et/ou du nickel, et/ou du titane, et/ou de l'erbium.

Le dispositif peut comporter en outre, lorsqu'il comporte au moins trois éléments semi-conducteurs et six portions d'interface :

- des moyens d'application d'une tension U entre deux portions d'interface recouvrant deux faces opposées d'un même élément semi-conducteur,
- des moyens de mesure d'un courant I circulant dans les éléments semi-conducteurs et dans les portions d'interface,
- des moyens de calcul d'une résistance R = U/I de chacun des éléments semi-conducteur et des portions d'interface,
- des moyens de calcul d'une régression linéaire de la fonction R = f (W) tel que R = a.W + b, avec a et b nombres réels, à partir des calculs de R et des largeurs W des différents éléments semi-conducteurs qui peuvent être de même longueur,

- des moyens de calcul de $W_{r\acute{e}el} = W - \dfrac{b}{a}$ pour chaque valeur de W,

- des moyens de calcul d'une régression linéaire de la fonction R = f(L) tel que R = c.L + d, avec c et d nombres réels, à partir des calculs de R et des longueurs L des différents éléments semi-conducteurs qui peuvent être de même largeur,
- des moyens de calcul de :

$$\rho_c = 2R_c \times W_{r\acute{e}el} \times t, \quad avec \ 2R_c = d.$$

La régression linéaire de la fonction R = f(L) et/ou le calcul de $\rho_c$ peuvent être réalisés pour tous les W différents, permettant ainsi d'obtenir des données statistiques (moyenne, écart type, ...).

La présente invention concerne également un procédé de réalisation d'un dispositif de mesure de résistivité $\rho_c$ d'une interface entre un semi-conducteur et un métal, comportant au moins les étapes de :

- réalisation, sur une couche diélectrique, d'au moins un élément à base du semi-conducteur, de forme sensiblement rectangulaire, ayant une face de longueur L et de largeur W en contact avec la couche diélectrique et ayant une épaisseur t,
- réalisation d'au moins deux portions d'interface à base du métal ou d'un alliage dudit semi-conducteur et dudit métal, chacune de deux faces opposées de l'élément semi-conducteur, de surface égale à W × t et sensiblement perpendiculaires à la face en contact avec la couche diélectrique, étant complètement recouverte par une des portions d'interface.

L'étape de réalisation de l'élément semi-conducteur peut réaliser également, sur la couche diélectrique, au moins deux autres éléments à base du semi-conducteur, chacun de ces deux éléments étant de forme sensiblement rectangulaire, ayant une face de longueur L et de largeur W en contact avec la couche diélectrique, et ayant une épaisseur t sensiblement similaire à l'épaisseur des autres éléments, les largeurs W des trois éléments étant différentes les unes des autres, au moins deux des trois longueurs L des trois éléments étant différentes l'une de l'autre.

L'étape de réalisation des deux portions d'interface peut réaliser également au moins quatre autres portions d'interface à base du métal ou d'un alliage dudit semi-conducteur et dudit métal, chacune de deux faces opposées d'un des deux autres élément semi-conducteur, de surface égale à W × t et sensiblement perpendiculaires à la face en contact avec la couche diélectrique, étant complètement recouverte par une des quatre autres portions d'interface.

La présente invention peut également concerner un procédé de réalisation d'un dispositif de mesure de résistivité $\rho_c$ d'une interface entre un semi-conducteur et un métal, pouvant comporter au moins les étapes de :

- réalisation, sur une couche diélectrique, d'au moins trois éléments à base du semi-conducteur, chaque élément étant de forme sensiblement rectangulaire, ayant une face de longueur L et de largeur W en contact avec la couche diélectrique, et ayant une épaisseur t sensiblement similaire à l'épaisseur des autres éléments, les largeurs W des trois éléments étant différentes les unes des autres, au moins deux des trois longueurs L des trois éléments étant différentes l'une de l'autre,
- réalisation d'au moins six portions d'interface à base du métal ou d'un alliage dudit semi-conducteur et dudit métal, chacune de deux faces opposées d'un élément semi-conducteur, de surface égale à W × t et sensiblement perpendiculaires à la face en contact avec la couche diélectrique, étant complètement recouverte par une des portions d'interface.

La réalisation du ou des éléments semi-conducteurs peut être obtenue au moins par la mise en oeuvre des étapes suivantes :

- réalisation, sur la couche diélectrique, d'un empilement comportant une couche à base du semi-conducteur sur laquelle est disposée une seconde couche diélectrique et une couche apte à former un masque de gravure,
- réalisation, dans la couche de masque, d'un motif de masque comportant au moins la ou les formes sensiblement rectangulaires de longueurs L et de largeurs W des éléments semi-conducteurs,
- gravure de la couche de masque, de la seconde couche diélectrique et de la couche à base du semi-conducteur selon le motif réalisé dans la couche de masque.

La réalisation de l'empilement peut être obtenue par des dépôts, par exemple des dépôts CVD (dépôt chimique en phase vapeur) ou PECVD (dépôt chimique en phase vapeur assisté par plasma), de la seconde couche diélectrique et de la couche de masque sur un substrat de type semi-conducteur sur isolant, ledit substrat formant la couche diélectrique et la couche à base du semi-conducteur.

Le procédé peut comporter en outre, pendant la réalisation de l'empilement, entre le dépôt de la seconde couche d'oxyde et le dépôt de la couche de masque, une étape de dopage de la couche à base du semi-conducteur à travers la seconde couche diélectrique.

Le motif peut être réalisé dans la couche de masque par la mise en oeuvre d'une étape de photolithographie ou de lithographie électronique.

La réalisation des portions d'interface peut être obtenue au moins par la mise en oeuvre des étapes suivantes :

- dépôt d'un matériau diélectrique au moins sur la couche diélectrique,
- définition, par photolithographie ou lithographie électronique, et gravure d'emplacements dans le matériau diélectrique, pouvant mettre à nu les deux faces opposées de chacun des éléments semi-conducteurs, de surface égale à $W \times t$ et perpendiculaires à la face en contact avec la couche diélectrique,
- dépôt du métal dans les emplacements, lesdites deux faces opposées de chacun des éléments semi-conducteurs pouvant être complètement recouvertes par le métal, pouvant former les portions d'interface et au moins deux contacts métalliques reliés électriquement à chaque portion d'interface lorsque les portions d'interface sont à base du métal.

Le procédé peut comprendre en outre, pour la réalisation des portions d'interface, lorsque les portions d'interface sont à base de l'alliage métal/semi-conducteur, après l'étape de dépôt du métal dans les emplacements :

- un recuit transformant le métal en contact avec les éléments semi-conducteur en l'alliage métal/semi-conducteur, cet alliage pouvant former les portions d'interface,
- suppression du métal non transformé en l'alliage métal/semi-conducteur.

Le procédé peut comprendre en outre, après l'étape de suppression du métal non transformé en l'alliage métal/semi-conducteur, une étape de dépôt, dans une partie des emplacements libérée par la suppression du métal non transformé en l'alliage métal/semi-conducteur, d'un empilement de couches métalliques, pouvant former au moins deux contacts métalliques reliés électriquement à chaque portion d'interface.

L'orientation cristalline des interfaces dont on cherche à mesurer la résistivité peut être définie par l'orientation cristalline initiale du substrat de départ et/ou par l'orientation cristalline des lithographies réalisées durant le procédé.

La présente invention peut également concerner un procédé de mesure de résistivité d'une interface entre un semi-conducteur et un métal formée sur un dispositif comportant :

- une couche diélectrique,
- au moins trois éléments à base du semi-conducteur disposés sur la couche diélectrique, chaque élément étant de forme sensiblement rectangulaire, ayant une face de longueur L et de largeur W en contact avec la couche diélectrique, et ayant une épaisseur t sensiblement similaire à l'épaisseur des autres éléments, les largeurs W des trois éléments étant différentes les unes des autres, au moins deux des trois longueurs L des trois éléments étant différentes l'une de l'autre,
- au moins six portions d'interface,
  chacune de deux faces opposées d'un élément semi-conducteur, de surface égale à $t \times W$ et perpendiculaires à la face en contact avec la couche diélectrique, pouvant être complètement recouverte par une des portions d'interface,
  le procédé de mesure comportant au moins les étapes suivantes :
- application d'une tension U entre deux portions d'interface recouvrant deux faces opposées d'un même élément semi-conducteur,

- mesure d'un courant I circulant dans les éléments semi-conducteurs et dans les portions d'interface,
- calcul d'une résistance R = U/I de chacun des éléments semi-conducteur et des portions d'interface,
- calcul d'une régression linéaire de la fonction R = f(W) tel que R = a.W + b, avec a et b nombres réels, à partir des calculs de R et des largeurs W des différents éléments semi-conducteurs,
- calcul de $W_{réel}$ = W - b/a pour chaque valeur de W,
- calcul d'une régression linéaire de la fonction R = f(L) tel que R = c.L + d, avec c et d nombres réels, à partir des calculs de R et des longueurs L des différents éléments semi-conducteurs,
- calcul de $\rho_c = 2R_c \times W_{réel} \times t$, avec $2R_c$ = d.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- les figures 1 et 2 représentent respectivement une vue en coupe et une vue de dessus d'une structure de type CKR selon l'art antérieur,
- les figures 3 à 8 représentent les étapes d'un procédé de réalisation d'un dispositif de mesure de résistivité d'une interface entre un semi-conducteur et un métal, objet de la présente invention,

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

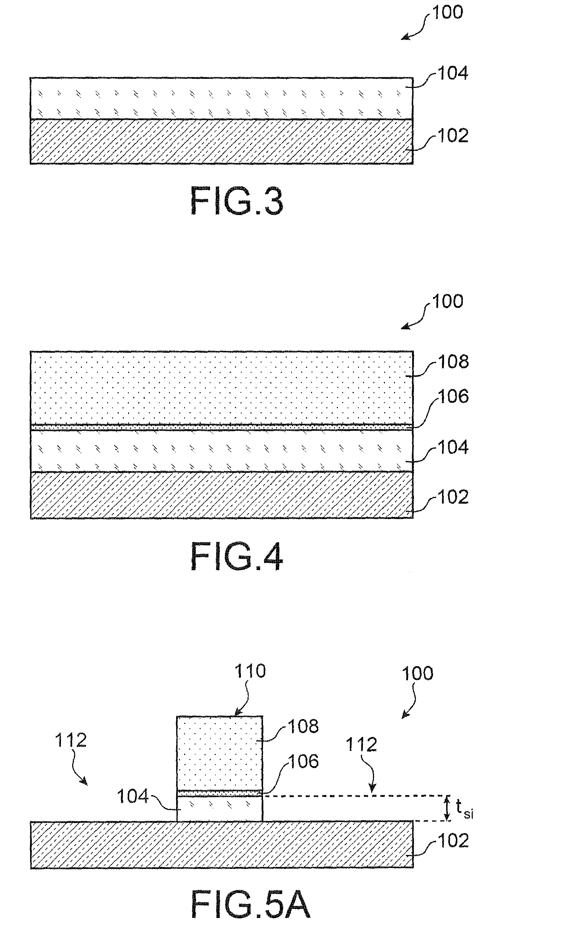

On se réfère tout d'abord aux figures 3 à 8 qui représentent les étapes d'un procédé de réalisation d'un dispositif 100 de mesure de résistivité d'une interface entre un semi-conducteur et un métal.

Comme représenté sur la figure 3, le procédé est mis en oeuvre à partir d'un empilement comportant une couche diélectrique 102, ici à base d'oxyde et d'épaisseur égale à environ 145 nm, sur laquelle est disposée une couche 104 à base du semi-conducteur destiné à former l'interface, par exemple du silicium, et d'épaisseur égale à environ 70 nm. La couche diélectrique 102 et la couche à base du semi-conducteur 104 forme donc ici un substrat de type SOI. Dans une variante, le semi-conducteur de la couche 104 pourrait également être du germanium, formant alors avec la couche diélectrique 102 un substrat de type GeOI (germanium sur isolant). De manière générale, la couche diélectrique 102 et la couche 104 à base de semi-conducteur forment un substrat de type semi-conducteur sur isolant.

On définit ensuite l'épaisseur $t_{si}$ de la couche 104 que l'on cherche à caractériser. Dans ce mode de réalisation, cette épaisseur est égale à environ 20 nm. Pour cela, on réalise une oxydation thermique de la surface de la couche 104, sur une épaisseur égale à environ 50 nm. On retire ensuite, ici par une désoxydation à l'acide fluorhydrique, la couche d'oxyde formée sur la couche 104, la couche de silicium 104 restante ayant alors une épaisseur égale à environ 20 nm. De manière générale, l'épaisseur $t_{si}$ de la couche 104 peut être comprise entre environ 1 nm et 50 nm. L'épaisseur $t_{si}$ de la couche 104 peut être mesurée précisément par ellipsométrie spectroscopique.

On dépose ensuite sur cette couche de silicium 104, par exemple par PECVD ou CVD, une seconde couche diélectrique 106, par exemple à base d'oxyde et d'épaisseur comprise entre environ 2 nm et 10 nm.

On réalise alors un dopage, par exemple par une implantation ionique mise en oeuvre par un faisceau d'ions arsenic d'énergie égale à environ 5 keV et de concentration égale à environ $1.10^{15}$ atomes/cm$^2$, de la couche de silicium 104 à travers la couche d'oxyde 106. La couche d'oxyde 106 permet d'emmagasiner les défauts structurels générés lors d'une implantation ionique. Un recuit d'activation électrique des dopants, par exemple un recuit dit « Spike » à environ 1050°C, est ensuite réalisé afin de réduire et d'ajuster la résistance de la couche de silicium 104 $R_{si}$ tel que $R_{si} \leq 100 \times R_c$, avec $R_c$ résistance de contact des interfaces dont on cherche à mesurer la résistivité.

Comme représenté sur la figure 4, on dépose ensuite une couche de nitrure 108, par exemple par un dépôt CVD ou PECVD, réalisant une couche de masque de gravure, d'épaisseur suffisante pour être utilisée comme couche d'arrêt durant une planarisation mécano-chimique (CMP). L'épaisseur de cette couche de nitrure 108 est par exemple comprise entre environ 100 nm et 200 nm. La couche d'oxyde 106 réalise ainsi un lien mécanique entre la couche de silicium 104 et la couche de nitrure 108.

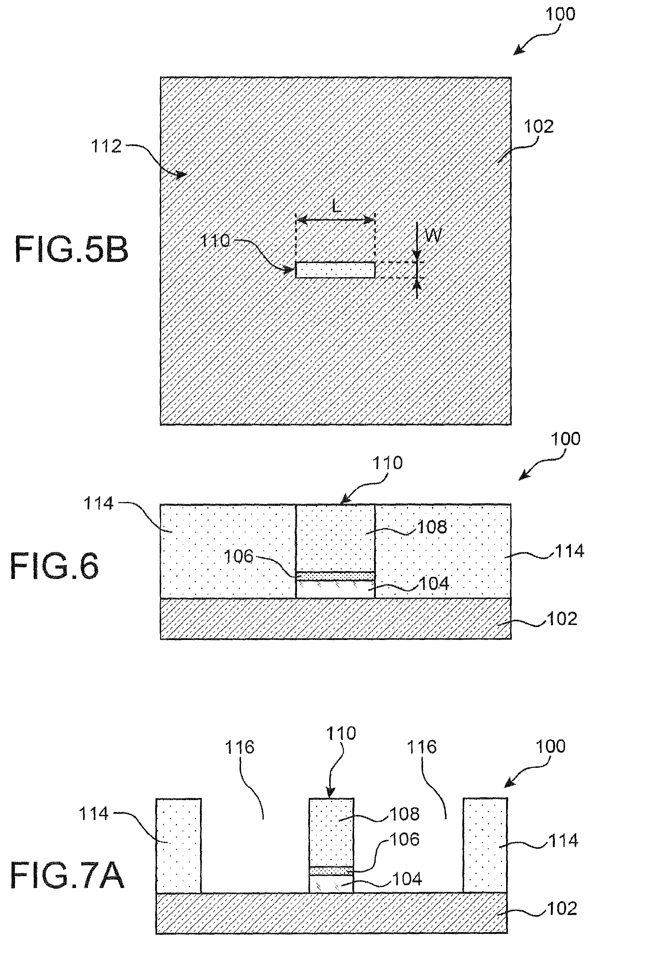

La couche de nitrure 108 est ici une couche de masque permettant de réaliser un masque de gravure qui va être utilisé pour graver la couche d'oxyde 106 et la couche de silicium 104. On réalise donc tout d'abord un motif dans la couche de nitrure 108, par exemple par photolithographie ou lithographie électronique, ce motif formant un masque de gravure définissant des zones actives et des zones d'isolation du dispositif 100. Comme représenté sur les figures 5A (vue en coupe) et 5B (vue de dessus), on réalise ensuite une gravure, par exemple une gravure ionique réactive, gravant les zones d'isolation 112 et conservant les zones actives 110. Le dispositif 100 comporte ici trois zones actives 110. Sur les figures 5A à 8, une seule zone active 110 comportant une portion restante des couches de silicium 104, d'oxyde 106 et de nitrure 108 est représentée, les zones où ont été supprimées des portions des couches de silicium 104, d'oxyde 106 et de nitrure 108 formant les zones d'isolation 112 du dispositif 100.

La zone active 110 a par exemple une longueur L et une largeur W comprises entre environ 30 nm et 2 μm. Ainsi, la couche de silicium forme un élément de silicium 104 de longueur L, de largeur W et d'épaisseur $t_{si}$, cet élément de silicium 104 formant la partie de semi-conducteur de l'interface dont la résistivité sera mesurée par la suite. Les autres zones actives du dispositif 100, non représentées, sont dimensionnées tel que chaque zone active comporte une longueur L et une largeur W différentes les unes des autres. De préférence, la structure 100 est réalisée avec au moins trois zones actives de différentes longueurs et de même largeur, et trois zones actives de différentes largeurs et de longueur identique. La structure 100 pourrait également être réalisée avec quatre zones actives, trois de ces zones comportant des largeurs différentes, deux de ces zones comportant une première longueur et deux autres zones comportant une seconde longueur différente de la première longueur. Il est également possible que le dispositif 100 comporte trois zones actives, les largeurs W des trois zones actives étant différentes les unes des autres, et au moins deux des trois longueurs L des trois zones actives étant différentes l'une de l'autre.

On recouvre ensuite l'ensemble du dispositif 100 d'un matériau diélectrique, ici une couche d'oxyde 114, déposée par exemple à basse température par PECVD, et on réalise une planarisation, par exemple mécano-chimique, de cette couche d'oxyde 114 en s'arrêtant sur la couche de nitrure 108 (figure 6).

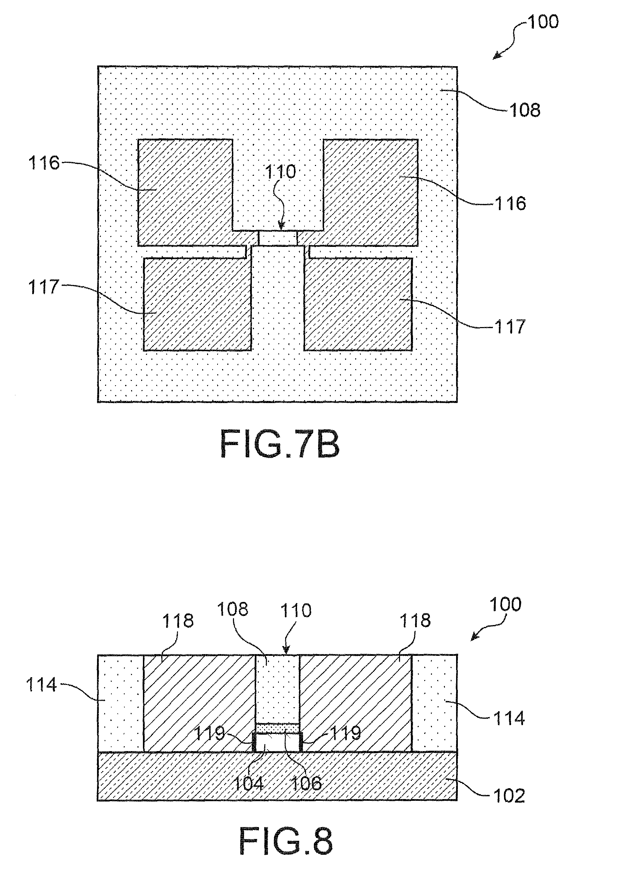

Comme représenté sur les figures 7A (vue en coupe) et 7B (vue de dessus), on met en oeuvre une seconde lithographie permettant de définir quatre emplacements 116 et 117 dans la couche d'oxyde 114 autour de chaque élément semi-conducteur 104, ces emplacements étant ensuite gravés, par exemple par une gravure plasma, dans la couche d'oxyde 114, la couche diélectrique 102 servant de couche d'arrêt. Cette gravure permet également de mettre à nu deux faces opposées de l'élément de silicium 104 de surface égale à t × W et perpendiculaires à la face en contact avec la couche diélectrique 102. Ces emplacements 116 et 117 sont destinés à recevoir du métal et ainsi former quatre contacts métalliques autour de chaque élément semi-conducteur 104, les deux contacts métalliques destinés à être réalisés dans les emplacements 116 les plus éloignés de l'élément de silicium 104 étant utilisés pour mesurer le courant traversant l'élément de silicium 104, les deux contacts métalliques destinés à être réalisés dans les emplacements 117 les plus proches de l'élément de silicium 104 étant utilisés pour mesurer la tension aux bornes de l'élément de silicium 104.

Les emplacements 116 et 117 sont ensuite remplis avec le métal destiné à former l'interface avec le semi-conducteur des éléments 104 (figure 8). Par exemple, une première couche à base dudit métal, qui peut être apte à former un siliciure avec le silicium 104, tel que du platine, et/ou du nickel, et/ou du titane, et/ou de l'erbium, est déposée dans les emplacements 116 et 117. Après un recuit permettant de former des portions d'interface 119 à base de siliciure, le métal restant est retiré sélectivement par rapport au siliciure, par exemple en utilisant de l'eau régale (mélange comportant de l'acide nitrique et de l'acide chlorhydrique) dans le cas d'un retrait sélectif de platine. Les emplacements 116 sont ensuite remplis avec un empilement 118 de couches métalliques constitué de métaux de résistivités différentes, par exemple du nitrure de titane et du tungstène. L'empilement 118 est alors planarisé de manière mécano-chimique, permettant d'enlever le métal se trouvant en dehors des emplacements 116 et 117.

A partir de ce dispositif 100, on peut maintenant mesurer la résistivité de contact au niveau des interfaces verticales entre le siliciure des portions d'interface 119 et le silicium 104 par l'intermédiaire des contacts métalliques 118.

A partir des éléments de silicium 104 de même longueur L et de différentes largeurs W, en appliquant des tensions U aux bornes de ces éléments 104 par l'intermédiaire des contacts métalliques réalisés et en mesurant le courant I circulant à travers ces éléments 104 et les portions d'interface 119, on trace tout d'abord R (= U/I) en fonction des différentes valeurs de W des éléments de silicium 104. Par exemple, à partir de trois valeurs de R, on peut tracer une régression linéaire de cette courbe. En effet, aux bornes de chacun des éléments de silicium 104, on a R = $R_{Si}$ + 2Rc. Ainsi, la résistance calculée R pour un élément de silicium 104 correspond à la résistance $R_{Si}$ de la portion de silicium 104 et de la résistance de contact Rc des deux interfaces entre le silicium 104 et une portion d'interface 119. On peut donc écrire l'équation : R = $\rho_{si}$ × W × L + 2$\rho_c$ × t × W. Etant donné qu'il peut y avoir une différence entre les dimensions réelles W, L et les valeurs théoriques $W_{dessiné}$ et $L_{dessiné}$, on peut extraire à partir de la courbe tracée un $\Delta W$, tel que $W_{réel}$ = $W_{dessiné}$ + $\Delta W$, correspondant à la valeur de W de la courbe pour R = 0.

On trace ensuite R en fonction de L pour toutes les largeurs dessinées ($W_{dessiné}$), par exemple trois si le dispositif comporte 3 éléments 104 à base de semi-conducteur de longueurs L différentes les unes des autres. Si la longueur L des éléments de silicium 104 est bien connue, on a alors l'ordonnée à l'origine (pour L=0 ) égale à 2$R_c$ = $\rho_c$ / ( $W_{réel}$ × $t_{si}$). Ainsi, il est possible d'en déduire la valeur de la résistivité $\rho_c$ de l'interface entre le semi-conducteur 104 et le siliciure des portions d'interface 119 en contact avec ce semi-conducteur 104. S'il existe une incertitude sur la largeur, en se plaçant à une longueur donnée L, il est également possible d'obtenir la valeur de $\rho_c$ à partir de la relation : $R_{W1}(L)-R_{W2}(L)=2\rho_c/(t_{si} \times (W1-W2))$. On en déduit ensuite la valeur de la résistivité $\rho_c$.

Des moyens classiques, non représentés, permettant l'application des tensions U et la mesure des courants I, ainsi que des moyens classiques pour réaliser les calculs ci-dessus, peuvent être intégrés au dispositif 100.

## Revendications

1. Dispositif (100) de mesure de résistivité $\rho_c$ d'une interface entre un semi-conducteur (104) et un métal (119), comportant au moins :

   - une couche diélectrique (102),
   - au moins un élément (104), à base du semi-conducteur, disposé sur la couche diélectrique (102), de forme sensiblement rectangulaire, ayant une face de longueur L et de largeur W en contact avec la couche diélectrique (102) et ayant une épaisseur t,
   - au moins deux portions d'interface (119) à base du métal ou d'un alliage dudit semi-conducteur et dudit métal,

   chacune de deux faces opposées de l'élément semi-conducteur (104), de surface égale à t × W et perpendiculaires à la face en contact avec la couche diélectrique (102), étant complètement recouverte par une des portions d'interface (119).

2. Dispositif (100) selon la revendication 1, comportant en outre :

   - au moins deux autres éléments à base du semi-conducteur, disposés sur la couche diélectrique (102), chacun de ces deux éléments étant de forme sensiblement rectangulaire, ayant une face de longueur L et de largeur W en contact avec la couche diélectrique (102), et ayant une épaisseur t sensiblement similaire à l'épaisseur des autres éléments (104), les largeurs W des trois éléments semi-conducteurs (104) étant différentes les unes des autres, au moins deux des trois longueurs L des trois éléments semi-conducteurs (104) étant différentes l'une de l'autre,
   - au moins quatre autres portions d'interface (119) à base du métal ou d'un alliage dudit semi-conducteur et dudit métal,

   chacune de deux faces opposées d'un des deux autres éléments semi-conducteurs (104), de surface égale à t × W et perpendiculaires à la face en contact avec la couche diélectrique (102), étant complètement recouverte par une des quatre autres portions d'interface (119).

3. Dispositif (100) selon l'une des revendications précédentes, chaque portion d'interface (119) étant reliée électriquement à au moins deux contacts métalliques (118).

4. Dispositif (100) selon la revendication 3, chaque contact métallique (118) comportant un empilement de couches métalliques.

5. Dispositif (100) selon la revendication 4, les couches métalliques étant à base de nitrure de titane et de tungstène.

6. Dispositif (100) selon l'une des revendications précédentes, les portions d'interface (119) étant à base de siliciure dudit métal.

7. Dispositif (100) selon l'une des revendications précédentes, l'épaisseur t étant comprise entre environ 1 nm et 50 nm, les largeurs W et longueurs L étant comprises entre environ 30 nm et 2 $\mu$m.

8. Dispositif (100) selon l'une des revendications précédentes, le semi-conducteur étant du silicium, et/ou du germanium et/ou du silicium-germanium.

9. Dispositif (100) selon l'une des revendications précédentes, le semi-conducteur étant dopé.

10. Dispositif (100) selon l'une des revendications précédentes, le métal étant du platine, et/ou du nickel, et/ou du titane, et/ou de l'erbium.

**11.** Dispositif (100) selon l'une des revendications précédentes, comportant en outre, lorsque le dispositif (100) comporte au moins trois éléments semi-conducteurs (104) et six portions d'interface (119) :

- des moyens d'application d'une tension U entre deux portions d'interface (119) recouvrant deux faces opposées d'un même élément semi-conducteur (104),
- des moyens de mesure d'un courant I circulant dans les éléments semi-conducteurs (104) et dans les portions d'interface (119),
- des moyens de calcul d'une résistance R = U/I de chacun des éléments semi-conducteurs (104) et des portions d'interface (119),
- des moyens de calcul d'une régression linéaire de la fonction R = f(W) tel que R = a.W + b, avec a et b nombres réels, à partir des calculs de R et des largeurs W des différents éléments semi-conducteurs (104),
- des moyens de calcul de $W_{réel}$ = W - b/a pour chaque valeur de W,
- des moyens de calcul d'une régression linéaire de la fonction R = f(L) tel que R = c.L + d, avec c et d nombres réels, à partir des calculs de R et des longueurs L des différents éléments semi-conducteurs (104),
- des moyens de calcul de :

$$\rho_c = 2R_c \times W_{réel} \times t, \text{ avec } 2R_c = d.$$

**12.** Procédé de réalisation d'un dispositif (100) de mesure de résistivité $\rho_c$ d'une interface entre un semi-conducteur (104) et un métal (119), comportant au moins les étapes de :

- réalisation, sur une couche diélectrique (102), d'au moins un élément (104) à base du semi-conducteur, de forme sensiblement rectangulaire, ayant une face de longueur L et de largeur W en contact avec la couche diélectrique (102) et ayant une épaisseur t,
- réalisation d'au moins deux portions d'interface (119) à base du métal ou d'un alliage dudit semi-conducteur et dudit métal, chacune de deux faces opposées de l'élément semi-conducteur (104), de surface égale à W × t et sensiblement perpendiculaires à la face en contact avec la couche diélectrique (102), étant complètement recouverte par une des portions d'interface (119).

**13.** Procédé selon la revendication 12, dans lequel :

- l'étape de réalisation de l'élément semi-conducteur (104) réalisant également, sur la couche diélectrique (102), au moins deux autres éléments à base du semi-conducteur, chacun de ces deux éléments étant de forme sensiblement rectangulaire, ayant une face de longueur L et de largeur W en contact avec la couche diélectrique (102), et ayant une épaisseur t sensiblement similaire à l'épaisseur des autres éléments (104), les largeurs W des trois éléments (104) étant différentes les unes des autres, au moins deux des trois longueurs L des trois éléments (104) étant différentes l'une de l'autre,
- l'étape de réalisation des deux portions d'interface (119) réalisant également au moins quatre autres portions d'interface (119) à base du métal ou d'un alliage dudit semi-conducteur et dudit métal, chacune de deux faces opposées d'un des deux autres élément semi-conducteur (104), de surface égale à W × t et sensiblement perpendiculaires à la face en contact avec la couche diélectrique (102), étant complètement recouverte par une des quatre autres portions d'interface (119).

**14.** Procédé selon l'une des revendications 12 ou 13, la réalisation du ou des éléments semi-conducteur (104) étant obtenue au moins par la mise en oeuvre des étapes suivantes :

- réalisation, sur la couche diélectrique (102), d'un empilement comportant une couche à base du semi-conducteur (104) sur laquelle est disposée une seconde couche diélectrique (106) et une couche (108) apte à former un masque de gravure,
- réalisation, dans la couche de masque (108), d'un motif de masque comportant au moins la ou les formes sensiblement rectangulaires de longueurs L et de largeurs W du ou des éléments semi-conducteurs (104),
- gravure de la couche de masque (108), de la seconde couche diélectrique (106) et de la couche à base du semi-conducteur (104) selon le motif réalisé dans la couche de masque (108).

**15.** Procédé selon la revendication 14, la réalisation de l'empilement étant obtenue par des dépôts de la seconde couche diélectrique (106) et de la couche de masque (108) sur un substrat de type semi-conducteur sur isolant, ledit substrat formant la couche diélectrique (102) et la couche à base du semi-conducteur (104).

**16.** Procédé selon la revendication 15, comportant en outre, pendant la réalisation de l'empilement, entre le dépôt de la seconde couche d'oxyde (106) et le dépôt de la couche de masque (108), une étape de dopage de la couche à base du semi-conducteur (104) à travers la seconde couche diélectrique (106).

**17.** Procédé selon l'une des revendications 14 à 16, le motif étant réalisé dans la couche de masque (108) par la mise en oeuvre d'une étape de photolithographie ou de lithographie électronique.

**18.** Procédé selon l'une des revendications 14 à 17, la réalisation des portions d'interface (119) étant obtenue au moins par la mise en oeuvre des étapes suivantes :

- dépôt d'un matériau diélectrique (114) au moins sur la couche diélectrique (102),
- définition, par photolithographie ou lithographie électronique, et gravure d'emplacements (116, 117) dans le matériau diélectrique (114), mettant à nu les deux faces opposées du ou de chacun des éléments semi-conducteurs (104), de surface égale à $W \times t$ et perpendiculaires à la face en contact avec la couche diélectrique (102),
- dépôt du métal dans les emplacements (116, 117), lesdites deux faces opposées du ou de chacun des éléments semi-conducteurs (104) étant complètement recouvertes par le métal, formant les portions d'interface et au moins deux contacts métalliques reliés électriquement à chaque portion d'interface lorsque les portions d'interface sont à base du métal.

**19.** Procédé selon la revendication 18, comprenant en outre, pour la réalisation des portions d'interface (119), lorsque les portions d'interface (119) sont à base de l'alliage métal/semi-conducteur, après l'étape de dépôt du métal dans les emplacements :

- un recuit transformant le métal en contact avec le ou les éléments semi-conducteur (104) en l'alliage métal/semi-conducteur, cet alliage formant les portions d'interface (119),
- suppression du métal non transformé en l'alliage métal/semi-conducteur.

**20.** Procédé selon la revendication 19, comprenant en outre, après l'étape de suppression du métal non transformé en l'alliage métal/semi-conducteur, une étape de dépôt, dans une partie des emplacements (116, 117) libérée par la suppression du métal non transformé en l'alliage métal/semi-conducteur, d'un empilement de couches métalliques (118), formant au moins deux contacts métalliques reliés électriquement à chaque portion d'interface (119).

FIG.1

FIG.2

100

104

102

# FIG.3

100

108

106

104

102

# FIG.4

110

112

100

108

106

112

104

$t_{si}$

102

# FIG.5A

FIG.5B

FIG.6

FIG.7A

FIG.7B

FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **G. REEVES et al.** Electrical modelling of kelvin structures for the derivation of low specific contact resistivity. *ESSDERC,* 1997
- **A.S. HOLLAND et al.** New challenges of the modelling of electrical characterization of ohmic contacts for ULSI devices. *international Conf of Microelec (MIEL,* 2000
- **W.M. LOH et al.** 2D simulations for accurate extraction of the specific contact resistivity from contact résistance data. *IEDM,* 1985, 25.1
- **E.DUBOIS et al.** Measurement of low Schottky barrier heights applied to metallic source/drain metaloxide-semiconductor field effect transistors. *Journ. Of Appl. Phys.,* 2004, 729